# EUROPÄISCHE PATENTSCHRIFT

(11) **EP 1 940 968 B1**
(45) Veröffentlichungstag und Bekanntmachung des Hinweises auf die Patenterteilung: **11.03.2009**
(21) Anmeldenummer: 06805696.9
(22) Anmeldetag: 12.09.2006
(51) Int. Cl.: C09B 67/04, C08K 5/3415, G03F 1/10, G03F 7/00, C09B 67/22

(54) **PIGMENTZUBEREITUNGEN AUF BASIS VON DIKETOPYRROLOPYRROLEN**
PIGMENT PREPARATIONS BASED ON DIKETOPYRROLOPYRROLES
PRÉPARATIONS PIGMENTAIRES À BASE DE DICÉTOPYRROLOPYRROLES

(30) Priorität: 21.10.2005 DE 102005050512
(43) Veröffentlichungstag der Anmeldung: 09.07.2008
(73) Patentinhaber: Clariant Produkte (Deutschland) GmbH, 65929 Frankfurt am Main (DE)
(72) Erfinder: REIPEN, Tanja, 55124 Mainz (DE); PLÜG, Carsten, 64367 Mühltal/Niederbeerbach (DE); WEBER, Joachim, CH-4153 Reinach (CH)
(74) Vertreter: Hütter, Klaus
(86) Internationale Anmeldenummer: PCT/EP2006/008866
(87) Internationale Veröffentlichungsnummer: WO 2007/045311

(56) Entgegenhaltungen:
- EP-A2- 1 104 789
- WO-A-01/04215

## Beschreibung

Die vorliegende Erfindung betrifft neue Pigmentzubereitungen mit C.I**.** Pigment Red 254 als Basispigment und bestimmten amingruppenhaltigen oder anionischen Pigmentdispergatoren.

Pigmentzubereitungen sind Kombinationen von Basispigmenten und so genannten Pigmentdispergatoren, das sind mit spezifisch wirksamen Gruppen substituierte Pigmente. Die Pigmentdispergatoren werden den Pigmenten zugesetzt, um die Dispergierung in den Anwendungsmedien, insbesondere in Lacken, Druckfarben und Tinten zu erleichtern und um die rheologischen und coloristischen Eigenschaften der Pigmente zu verbessern. Dadurch kann beispielsweise die Farbstärke, die Transparenz und der Glanz in vielen Anwendungen erhöht werden.
Zur Herstellung von Farbfiltern werden besonders feinteilige Pigmente eingesetzt, um die Partikel-Streuung, die zu einer Herabsetzung des Kontrastverhältnisses führt, weitgehend auszuschließen.

WO 01/04215 offenbart ein feinteiliges Diketopyrrolopyrrolpigment, C.I. Pigment Red 254 (I), 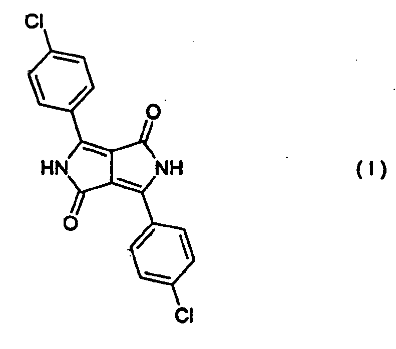 das durch eine besonders enge Teilchengrößenverteilung gepaart mit hoher Kristallinität und einer speziellen Absorptionscharakteristik gekennzeichnet ist. Ein solches C.I. Pigment Red 254 kann erhalten werden, indem ein Rohpigment zunächst mit einem anorganischen Salz trocken bei mindestens 80°C gerührt und anschließend einem Knetprozess mit anorganischen Salzen in Gegenwart von organischen Lösungsmitteln ausgesetzt wird.

Basierend auf diesem bekannten Verfahren sind Handelsprodukte. kommerziell erhältlich und werden für die Anwendung, in denen hohe Transparenz erforderlich ist, beispielsweise in Farbfiltern, empfohlen. Diese Pigmente genügen jedoch nicht immer allen Anforderungen der Technik. Insbesondere bestand ein Verbesserungsbedarf hinsichtlich der Transparenz, Dispergierbarkeit und Rheologie.

Die EP-A-1 104 789 beschreibt Pigmentdispergatoren auf Basis von Pigmenten, wie z.B. von Diketopyrrolopyrrolen oder Chinacridonen.

Es bestand die Aufgabe, Pigmentzubereitungen mit C.I. Pigment Red 254 als Basispigment zur Verfügung zu stellen, die hohe Farbstärke, niedrige Viskosität und möglichst geringe Farbtonabweichung vom Basispigment C.I. Pigment Red 254 aufweisen und insbesondere für Farbfilteranwendungen geeignet sind.

Es wurde gefunden, dass Pigmentzubereitungen auf Basis von C.I. Pigment Red 254 mit bestimmter Teilchengröße und den nachstehend definierten Pigmentdispergatoren diese Aufgabe lösen, obwohl aufgrund der Coloristik der Einzelverbindungen eine deutlich größere Farbtonabweichung zu erwarten gewesen wäre.

Gegenstand der Erfindung sind Pigmentzubereitungen, gekennzeichnet durch einen Gehalt von C.I. Pigment Red 254 mit einer mittleren Teilchengröße d₅₀ von 20 bis 100 nm, und mindestens einem Pigmentdispergator der Formel (II) und/oder (III) 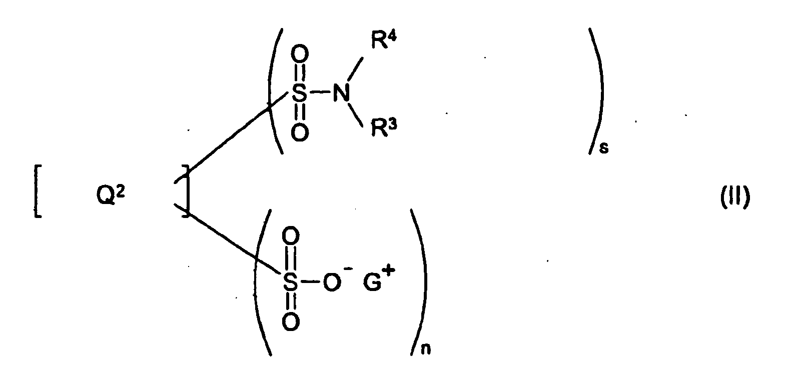 worin
- Q²: ein Rest eines organischen Pigments ausgewählt aus der Gruppe C.I. Pigment Red 264 und C.I. Pigment Violet 19 ist;
- s: eine Zahl von 1 bis 5, vorzugsweise 1 bis 3, darstellt;
- n: eine Zahl von 0 bis 4, vorzugsweise 0 bis 2, darstellt; wobei die Summe von s und n 1 bis 5 beträgt;
- R³: einen verzweigten oder unverzweigten, gesättigten oder ungesättigten, aliphatischen Kohlenwasserstoffrest mit 1 bis 20 C-Atomen, oder einen C₅-C₇-Cycloalkylenrest, oder einen araliphatischen oder aromatischen Rest mit 1, 2 oder 3 aromatischen Ringen, wobei die Ringe kondensiert vorliegen oder durch eine Bindung verknüpft sein können, oder einen heterocyclischen Rest mit 1, 2 oder 3 Ringen, enthaltend 1, 2, 3 oder 4 Heteroatome aus der Gruppe O, N und S, oder eine Kombination davon bedeutet; wobei die genannten Kohlenwasserstoff-, Cycloalkylen-, Aromaten-, Araliphaten- und Heteroaromaten-Reste durch 1, 2, 3 oder 4 Substituenten aus der Gruppe COOR⁵, oder, SO₃R⁵ substituiert sind wobei R⁵ Wasserstoff, Phenyl oder C₁₋C₆-Alkyl bedeuten;
- R⁴: Wasserstoff, R³ oder C₁-C₆-Alkyl-COO⁻E⁺ bedeutet;
- E⁺, G⁺: unabhängig voneinander H⁺ oder das Äquivalent M^{p+}/m eines Metallkations M^{p+} aus der 1. bis 5. Hauptgruppe oder aus der 1. oder 2. oder der 4. bis 8. Nebengruppe des Periodensystems der chemischen Elemente bezeichnet, wobei m eine der Zahlen 1, 2 oder 3 und p die Zahl 1, 2 oder 3 bedeutet; oder ein substituiertes oder unsubstituiertes Ammoniumion bezeichnet; 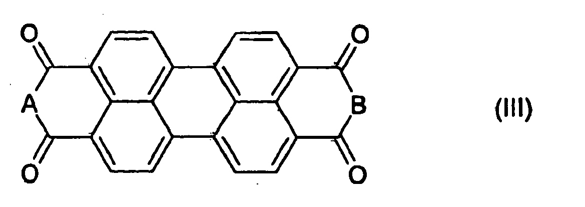
worin
- A: einen bivalenten Rest -O-, -NR³-, -NR¹⁶-SO₃⁻ G⁺,
- B: einen bivalenten Rest -NR¹⁶-SO₃⁻ G⁺,
wobei R¹⁶ für eine geradkettige oder verzweigte C₁-C₆-Alkylenkette steht und R³ und G⁺ die vorstehend genannten Bedeutungen besitzen.

In bevorzugten Pigmentdispergatoren der Formel (III) bedeutet
- A: ein bivalenter Rest -NR³ und
- B: die vorstehenden bevorzugten Bedeutungen,
- G⁺: Wasserstoff oder ein Alkalimetall, insbesondere Li, Na oder K.

Für den Fall, dass E⁺ und G⁺ ein Ammoniumion darstellen, kommen dafür in Betracht:
(i) NR⁷R⁸R⁹R¹⁰, wobei die Substituenten R⁷, R⁸, R⁹ und R¹⁰ unabhängig voneinander jeweils ein Wasserstoffatom, C₁₋C₃₀-Alkyl, C₂-C₃₀-Alkenyl, C₅-C₃₀-Cycloalkyl, Phenyl, (C₁-C₈)Alkyl-phenyl, (C₁-C₄)Alkylen-phenyl, oder eine (Poly)alkylenoxy-gruppe der Formel -[CH(R¹¹)-CH(R¹¹)-O]ₖ-H sind, in der k eine Zahl von 1 bis 30 ist und die beiden Reste R¹¹ unabhängig voneinander Wasserstoff, C₁-C₄-Alkyl oder, sofern k > 1 ist, eine Kombination davon bedeuten: und worin als R⁷, R⁸, R⁹ und/oder R¹⁰ ausgewiesenes Alkyl, Alkenyl, Cyclophenyl, Phenyl oder Alkylphenyl durch Amino, Hydroxy, und/oder Carboxy substituiert sein können:
   oder wobei die Substituenten R⁷ und R⁸ zusammen mit dem quartären N-Atom ein fünf- bis siebengliedriges gesättigtes Ringsystem, das ggf. noch weitere Heteroatome aus der Gruppe O, S und N enthält, bilden können;
   oder wobei die Substituenten R⁷, R⁸ und R⁹ zusammen mit dem quartären N-Atom ein fünf- bis siebengliedriges aromatisches Ringsystem, das ggf. noch weitere Heteroatome aus der Gruppe O, S und N enthält und an dem ggf. zusätzliche Ringe ankondensiert sind, bilden können;
      oder
(ii) ein Ammoniumion der Formel (IIIa), 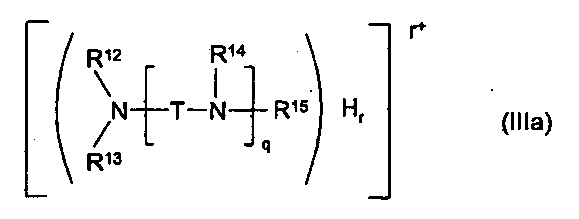
worin
- R¹², R¹³, R¹⁴ und R¹⁵: unabhängig voneinander Wasserstoff oder eine (Poly)alkylenoxygruppe der Formel -[CH(R¹¹)-CH(R¹¹)O]ₖ-H bedeuten, in der k und R¹¹ die oben genannte Bedeutung haben;
- q: eine Zahl von 1 bis 10;
- r: eine Zahl von 1 bis 5, wobei r ≤ q+1 ist;
- T: einen verzweigten oder unverzweigten C₂-C₆-Alkylenrest bedeutet; oder worin T, wenn q > 1 ist, auch eine Kombination von verzweigten oder unverzweigten C₂-C₆-Alkylenresten sein kann.

Die Pigmentdispergatoren der Formel (II) sind an sich bekannte Verbindungen und lassen sich nach bekannten Verfahren herstellen, z.B. nach EP-A-1 104 789 oder WO 02/064 680.

Die Pigmentdispergatoren der Formel (III) sind an sich bekannte Verbindungen und lassen sich nach bekannten Verfahren herstellen, z.B: nach EP-A-0 486 531.

In den erfindungsgemäßen Pigmentzubereitungen ist das Gewichtsverhältnis von C.I. Pigment Red 254 zu Pigmentdispergator der Formel (II) und/oder(III) bevorzugt zwischen (99,9 zu 0,1) und (80 zu 20), besonders bevorzugt zwischen (99 zu 1) und (89 zu 11), insbesondere zwischen (98 zu 2) und (90 zu 10), und ganz besonders bevorzugt zwischen (97 zu 3) und (92 zu 8).

Für eine Mischung der Komponenten C. I. Pigment Red 254 und dem erfindungsgemäßen Pigmentdispergator im beanspruchten Mengenverhältnis wäre eine Abweichung von ΔH und ΔC jeweils größer als 3,0 zu erwarten.

Überraschenderweise zeigte sich jedoch, dass eine Färbung nach DIN EN ISO 787-26 mit 1/3 Standard-Farbtiefe im Alkyd/Melaminharz-Lacksystem mit einer erfindungsgemäßen Pigmentzubereitung im Vergleich zu einer Färbung des entsprechenden Diketopyrrolopyrrols bei 1/3 Standard-Farbtiefe und gleicher Teilchengröße ein ΔH (nach CIELAB) von vorzugsweise nicht mehr als 2,0, insbesondere nicht mehr als 1,5 und besonders bevorzugt von nicht mehr als 1,0 aufweist. Vorzugsweise ist das ΔC (nach CIELAB) nicht größer als 2,0, insbesondere nicht größer als 1,5 und besonders bevorzugt nicht größer als 1,0. Chroma (C) ist der Parameter, der die Buntheit der Farbe bei gegebener Helligkeit beschreibt, ΔC beschreibt die Differenz in der Buntheit von zwei Farben. Analog beschreibt ΔH den Unterschied im Farbton bei zwei zu vergleichenden Farben.

Die erfindungsgemäßen Pigmentzubereitungen sind vorzugsweise hochkristallin, gekennzeichnet durch eine Halbwertsbreite HWB des Hauptpeaks von 0,2 bis 0,7 °2Theta, insbesondere von 0,3 bis 0,5 °2Theta, im Röntgenpulverdiffraktogramm mit CuKₐₗₚₕₐ Strahlung.

Die erfindungsgemäßen Pigmentzubereitungen enthalten das Basispigment mit einer mittleren Teilchengröße d₅₀ von 20 bis 100 nm, vorzugsweise 30 bis 80. nm. Die Teilchengrößenverteilung von C.I. Pigment Red 254 ist vorzugsweise einer Gauss-Verteilung angenähert, in der die Standardabweichung □ vorzugsweise kleiner als 40 nm, besonders bevorzugt kleiner als 30 nm, ist. In der Regel liegen die Standardabweichungen zwischen 5 und 40 nm, vorzugsweise zwischen 10 und 30 nm.

Die erfindungsgemäßen Pigmentzubereitungen haben überraschenderweise eine sehr geringe Viskosität, vorzugsweise eine Viskosität von 3 bis 50 mPas, gemessen bei 20°C mit einem Kegel-Platte-Viskosimeter, z.B. RS75 der Fa. Haake.

Die erfindungsgemäßen Pigmentzubereitungen können neben dem Diketopyrrolopyrrolpigment und dem Pigmentdispergator noch weitere übliche Hilfsmittel oder Zusatzstoffe enthalten, wie beispielsweise Tenside, Dispergiermittel, Füllstoffe, Stellmittel, Harze, Wachse, Entschäumer. Antistaubmittel, Extender, Antistatika, Konservierungsmittel, Trocknungsverzögerungsmittel, Netzmittel, Antioxidantien, UV-Absorber und Lichtstabilisatoren, vorzugsweise in einer Menge von 0,1 bis 10 Gew.-%, insbesondere 0,5 bis 5 Gew.-%, bezogen auf das Gesamtgewicht der Pigmentzubereitung.

Als Tenside kommen anionische oder anionaktive, kationische oder kationaktive und nichtionische oder amphotere Substanzen oder Mischungen dieser Mittel in Betracht.

Als anionaktive Substanzen kommen beispielsweise Fettsäuretauride, FettsäureN-methyltauride, Fettsäureisethionate, Alkylphenylsulfonate, beispielsweise Dodecylbenzolsulfonsäure, Alkylnaphthalinsulfonate, Alkylphenolpolyglykolethersulfate, Fettalkoholpolyglykolethersulfate, Fettsäureamid-polyglykolethersulfate, Alkylsulfosuccinamate, Alkenylbernsteinsäurehalbester, Fettalkoholpolyglykol-ethersulfosuccinate, Alkansulfonate, Fettsäureglutamate, Alkylsulfosuccinate, Fettsäuresarkoside; Fettsäuren, beispielsweise Palmitin-, Stearin- und Ölsäure; die Salze dieser anionischen Substanzen und Seifen, beispielsweise Alkalisalze von Fettsäuren, Naphthensäuren und Harzsäuren, beispielsweise Abietinsäure, alkalilösliche Harze, beispielsweise kolophoniummodifizierte Maleinatharze und Kondensationsprodukte auf Basis von Cyanurchlorid, Taurin, N,N'-Diethylamino-propylamin und p-Phenylendiamin in Betracht. Bevorzugt sind Harzseifen, d.h. Alkalisalze von Harzsäuren.
Als kationaktive Substanzen kommen beispielsweise quaternäre Ammoniumsalze, Fettaminoxalkylate, Polyoxyalkylenamine, oxalkylierte Polyamine, Fettaminpolyglykolether, primäre, sekundäre oder tertiäre Amine, beispielsweise Alkyl-, Cycloalkyl oder cyclisierte Alkylamine, insbesondere Fettamine, von Fettaminen oder Fettalkoholen abgeleitete Di- und Polyamine und deren Oxalkylate, von Fettsäuren abgeleitete Imidazoline, Polyaminoamido- oder Polyaminoverbindungen oder -harze mit einem Aminindex zwischen 100 und 800 mg KOH pro g der Polyaminoamido- oder Polyaminoverbindung, und Salze dieser kationenaktiven Substanzen, wie beispielsweise Acetate oder Chloride, in Betracht.

Als nichtionogene und amphotere Substanzen kommen beispielsweise Fettamincarboxyglycinate, Aminoxide, Fettalkoholpolyglykolether, Fettsäurepolyglykolester, Betaine, wie Fettsäureamid-N-propyl-betaine, Phosphorsäureester von aliphatischen und aromatische Alkoholen, Fettalkoholen oder Fettalkoholpoly-glykolethern, Fettsäureamidethoxylate, Fettalkohol-alkylenoxid-Addukte und Alkylphenolpolyglykolether in Betracht.

Mit nichtpigmentären Dispergiermitteln sind Substanzen gemeint, die strukturell nicht von organischen Pigmenten abgeleitet sind. Sie werden als Dispergiermittel entweder bereits bei der Herstellung von Pigmenten, oft aber auch bei der Einarbeitung der Pigmente in die zu färbenden Anwendungsmedien, beispielsweise bei der Herstellung von Colorfiltern durch Dispergierung der Pigmente in den entsprechenden Bindemitteln, zugegeben. Es können polymere Substanzen sein, beispielsweise Polyolefine, Polyester, Polyether, Polyamide, Polyimine, Polyacrylate, Polyisocyanate, Blockcopolymere daraus, Copolymere aus den entsprechenden Monomeren oder Polymere einer Klasse, die mit wenigen Monomeren einer anderen Klasse modifiziert sind. Diese polymeren Substanzen tragen polare Ankergruppen wie beispielsweise Hydroxy-, Amino-, Imino- und Ammoniumgruppen, Carbonsäure- und Carboxylatgruppen, Sulfonsäure- und Sulfonatgruppen oder Phosphonsäure- und Phosphonatgruppen, und können auch mit aromatischen, nicht pigmentären Substanzen modifiziert sein. Nichtpigmentäre Dispergiermittel können des Weiteren auch chemisch mit funktionellen Gruppen modifizierte aromatische, nicht von organischen Pigmenten abgeleitete Substanzen sein. Derartige nichtpigmentäre Dispergiermittel sind dem Fachmann bekannt und zum Teil im Handel erhältlich (z.B. Solsperse^{®}, Avecia; Disperbyk^{®}, Byk-Chemie, Efka^{®}, Efka). Es sollen im Folgenden stellvertretend einige Typen genannt werden, zum Einsatz können jedoch prinzipiell beliebige andere, beschriebene Substanzen kommen, beispielsweise Kondensationsprodukte aus Isocyanaten und Alkoholen, Di- oder Polyolen, Aminoalkoholen oder Di- oder Polyaminen, Polymere aus Hydroxycarbonsäuren, Copolymere aus Olefinmonomeren oder Vinylmonomeren und ethylenisch ungesättigten Carbonsäuren und -estern, urethanhaltige Polymere von ethylenisch ungesättigten Monomeren, urethanmodifizierte Polyester, Kondensationsprodukte auf Basis von Cyanurhalogeniden, Nitroxylverbindungen enthaltende Polymere, Polyesteramide, modifizierte Polyamide, modifizierte Acrylpolymere, Dispergiermittel mit kammartiger Struktur aus Polyestern und Acrylpolymeren, Phosphorsäureester, von Triazin abgeleitete Polymere, modifizierte Polyether, oder von aromatischen, nichtpigmentären Substanzen abgeleitete Dispergiermittel. Dabei werden diese Grundstrukturen vielfach weiter modifiziert, beispielsweise durch chemische Umsetzung mit weiteren, funktionelle Gruppen tragenden Substanzen oder durch Salzbildung.

Die erfindungsgemäße Pigmentzubereitung kann als vorzugsweise wässriger Presskuchen oder Feuchtgranulat zum Einsatz kommen, in der Regel handelt es sich jedoch um feste Systeme von pulverförmiger Beschaffenheit.

Gegenstand der Erfindung ist auch ein Verfahren zur Herstellung einer erfindungsgemäßen Pigmentzubereitung, dadurch gekennzeichnet, dass man C.I. Pigment Red 254 vor oder während einer Knetung, Nassmahlung, Trockenmahlung oder Finishbehandlung mit dem Pigmentdispergator der Formel (II) und/oder (III) versetzt.

Beispielsweise können die trockenen Komponenten in Granulat- oder Pulverform vor oder nach einer Mahlung gemischt werden; die eine Komponente kann zur anderen Komponente in feuchter oder trockener Form zugegeben werden, beispielsweise durch Mischen der Komponenten in Form der feuchten Presskuchen.
Das Mischen kann beispielsweise durch eine Mahlung in trockener Form, in feuchter Form, beispielsweise durch Knetung, oder in Suspension erfolgen, oder durch eine Kombination dieser Verfahren. Die Mahlung kann unter Zusatz von Wasser, Lösemitteln, Säuren oder Mahlhilfsmitteln wie Salz durchgeführt werden.

Das Mischen kann auch durch Zugabe des Pigmentdispergators während des Herstellungsprozess des C.I. Pigment Red 254 erfolgen.
Die Zugabe des Pigmentdispergators zum C.I. Pigment Red 254 erfolgt aber vorzugsweise nach der chemischen Bildung des C. I. Pigment Red 254 und vor oder während der Bildung der feinen Teilchen.
Besonders bevorzugt erfolgt die Zugabe des Pigmentdispergators zum Diketopyrrolopyrrolpigment während einer Trocken- oder Nassmahtung. Die dabei gebildete feinkristalline Pigmentzubereitung kann einer Nachbehandlung, im allgemeinen als Finish bezeichnet, unterworfen werden, beispielsweise in Wasser und/oder Lösemitteln und meist unter erhöhter Temperatur, beispielsweise bis 200°C, und ggf. erhöhtem Druck. Der Pigmentdispergator kann auch nach der Trocken- oder Nassmahlung, aber vor oder während des Finishs zugegeben werden. Selbstverständlich kann der Pigmentdispergator auch in Teilportionen zu unterschiedlichen Zeiten zugegeben werden.

Bei der Trocknung einer feuchten Pigmentzubereitung können die bekannten Trockenaggregate zum Einsatz kommen, wie Trockenschränke, Schaufelradtrockner, Taumeltrockner, Kontakttrockner und insbesondere Spinflash- und Sprühtrockner.

Die erfindungsgemäßen Pigmentzubereitungen zeichnen sich aus durch ihre hervorragenden coloristischen und rheologischen Eigenschaften, insbesondere hohe Flockungsstabilität, leichte Dispergierbarkeit, gute Rheologie, hohe Farbstärke, Transparenz und Sättigung (Chroma). Sie sind in vielen Anwendungsmedien leicht und bis zu hohen Feinheiten dispergierbar. Solche Pigmentdispersionen zeigen hervorragende rheologische Eigenschaften selbst bei hoher Pigmentierung der Lack- oder Druckfarbenkonzentrate. Auch andere Eigenschaften, wie beispielsweise Glanz, Überlackierechtheit, Lösemittelechtheit, Alkali- und Säureechtheit, Licht- und Wetterechtheiten und hohe Reinheit des Farbtons, sind sehr gut. Außerdem lassen sich mit den erfindungsgemäßen Pigmentzubereitungen Farbtöne im roten Bereich erzielen, die beim Einsatz in Farbfiltern gefragt sind. Hier sorgen sie für hohen Kontrast und genügen auch den sonstigen, beim Einsatz in Color Filtern gestellten Anforderungen, wie hohe Temperaturstabilität oder steile und schmale Absorptionsbanden. Sie können mit hoher Reinheit und niedrigen Gehalten an Ionen hergestellt werden.

Die erfindungsgemäßen Pigmentzubereitungen lassen sich prinzipiell zum Pigmentieren von allen hochmolekularen organischen Materialien natürlicher oder synthetischer Herkunft einsetzen, beispielsweise von Kunststoffen, Harzen, Lacken, Anstrichfarben, elektrophotographischen Tonern und Entwicklern, Elektretmaterialien, Farbfiltern sowie von Tinten, Druckfarben.

Hochmolekulare organische Materialien, die mit den erfindungsgemäßen Pigmentzubereitungen pigmentiert werden können, sind beispielsweise Celluloseverbindungen, wie beispielsweise Celluloseether und -ester, wie Ethylcellulose, Nitrocellulose, Celluloseacetate oder Cellulosebutyrate, natürliche Bindemittel, wie beispielsweise Fettsäuren, fette Öle, Harze und deren Umwandlungsprodukte, oder Kunstharze, wie Polykondensate, Polyaddukte, Polymerisate und Copolymerisate, wie beispielsweise Aminoplaste, insbesondere Harnstoff und Melaminformaldehydharze, Alkydharze, Acrylharze, Phenoplaste und Phenolharze, wie Novolake oder Resole, Harnstoffharze, Polyvinyle, wie Polyvinylalkohole, Polyvinylacetale, Polyvinylacetate oder Polyvinylether, Polycarbonate, Polyolefine, wie Polystyrol, Polyvinylchlorid, Polyethylen oder Polypropylen, Poly(meth)acrylate und deren Copolymerisate, wie Polyacrylsäureester oder Polyacrylnitrile, Polyamide, Polyester, Polyurethane, Cumaron-Inden- und Kohlenwasserstoffharze, Epoxidharze, ungesättigte Kunstharze (Polyester, Acrylate) mit den unterschiedlichen Härtemechanismen, Wachse, Aldehyd- und Ketonharze, Gummi, Kautschuk und seine Derivate und Latices, Casein, Silikone und Silikonharze; einzeln oder in Mischungen.
Dabei spielt es keine Rolle, ob die erwähnten hochmolekularen organischen Verbindungen als plastische Massen, Schmelzen oder in Form von Spinnlösungen, Dispersionen, Lacken, Anstrichstoffen oder Druckfarben vorliegen. Je nach Verwendungszweck erweist es sich als vorteilhaft, die erfindungsgemäßen Pigmentzubereitungen als Blend oder in Form von Präparationen oder Dispersionen zu benutzen.

Es ist auch möglich, die Pigmentzubereitung erst bei der Einarbeitung in das hochmolekulare organische Medium herzustellen.
Gegenstand der vorliegenden Erfindung ist daher auch ein hochmolekulares organisches Material, enthaltend eine färberisch wirksame Menge einer erfindungsgemäßen Pigmentzubereitung.
Bezogen auf das zu pigmentierende, hochmolekulare organische Material setzt man die erfindungsgemäße Pigmentzubereitung meist in einer Menge von 0,01 bis 30 Gew.%, vorzugsweise 0,1 bis 20 Gew.%, ein.
Die erfindungsgemäßen Pigmentzubereitungen sind auch geeignet als Farbmittel in elektrophotographischen Tonern und Entwicklern, wie beispielsweise Ein- oder Zweikomponentenpulvertonem (auch Ein- oder Zweikomponenten-Entwickler genannt), Magnettoner, Flüssigtoner, Polymerisationstoner sowie Spezialtoner. Typische Tonerbindemittel sind Polymerisations-, Polyadditions- und Polykondensationsharze, wie Styrol-, Styrolacrylat-, Styrolbutadien-, Acrylat-, Polyester-, Phenol-Epoxidharze, Polysulfone, Polyurethane, einzeln oder in Kombination, sowie Polyethylen und Polypropylen, die noch weitere Inhaltsstoffe, wie Ladungssteuermittel, Wachse oder Fließhilfsmittel, enthalten können oder im nachhinein mit diesen Zusätzen modifiziert werden.

Des weiteren sind die erfindungsgemäßen Pigmentzubereitungen geeignet als Farbmittel in Pulvern und Pulverlacken, insbesondere in triboelektrisch oder elektrokinetisch versprühbaren Pulverlacken, die zur Oberflächenbeschichtung von Gegenständen aus beispielsweise Metall, Holz, Kunststoff, Glas, Keramik, Beton, Textilmaterial, Papier oder Kautschuk zur Anwendung kommen.

Außerdem sind die erfindungsgemäßen Pigmentzubereitungen als Farbmittel in Ink-Jet Tinten auf wässriger und nichtwässriger Basis sowie in solchen Tinten, die nach dem Hot-melt-Verfahren arbeiten, geeignet.
Ink-Jet-Tinten enthalten im Allgemeinen insgesamt 0,5 bis 15 Gew.%, vorzugsweise 1,5 bis 8 Gew.-%, (trocken gerechnet) einer oder mehrerer der erfindungsgemäßen Pigmentzubereitungen.
Mikroemulsionstinten basieren auf organischen Lösemitteln, Wasser und ggf. einer zusätzlichen hydrotropen Substanz (Grenzflächenvermittler). Mikroemulsionstinten enthalten im Allgemeinen 0,5 bis 15 Gew.%, vorzugsweise 1,5 bis 8 Gew.%, einer oder mehrerer der erfindungsgemäßen Pigmentzubereitungen, 5 bis 99 Gew.-% Wasser und 0,5 bis 94,5 Gew.-% organisches Lösungsmittel und/oder hydrotrope Verbindung. "Solvent based" Ink-Jet-Tinten enthalten vorzugsweise 0,5 bis 15 Gew.-% einer oder mehrerer der erfindungsgemäßen Pigmentzubereitungen, 85 bis 99,5 Gew.-% organisches Lösungsmittel und/oder hydrotrope Verbindungen. Hot-Melt-Tinten basieren meist auf Wachsen, Fettsäuren, Fettalkoholen oder Sulfonamiden, die bei Raumtemperatur fest sind und bei Erwärmen flüssig werden, wobei der bevorzugte Schmelzbereich zwischen ca. 60°C und ca. 140°C liegt. Hot-Melt Ink-Jet-Tinten bestehen z.B. im Wesentlichen aus 20 bis 90 Gew.% Wachs und 1 bis 10 Gew.% einer oder mehrerer der erfindungsgemäßen Pigmentzubereitungen. Weiterhin können 0 bis 20 Gew.-% eines zusätzlichen Polymers (als "Farbstofflöser"), 0 bis 5 Gew.% Dispergierhilfsmittel, 0 bis 20 Gew.-% Viskositätsveränderer, 0 bis 20 Gew.-% Plastifizierer, 0 bis 10 Gew.-% Klebrigkeitszusatz, 0 bis 10 Gew.-% Transparenzstabilisator (verhindert z.B. Kristallisation der Wachse) sowie 0 bis 2 Gew.-% Antioxidans enthalten sein.

Insbesondere sind die erfindungsgemäßen Pigmentzubereitungen als Farbmittel für Farbfilter, sowohl für die additive wie auch für die subtraktive Farberzeugung, wie beispielsweise in elektro-optischen Systemen wie Fernsehbildschirmen, LCD (liquid crystal displays), charge coupled devices, plasma displays oder electroluminescent displays, die wiederum aktive (twisted nematic) oder passive (supertwisted nematic) ferroelectric displays oder light-emitting diodes sein können, sowie als Farbmittel für elektronische Tinten ("electronic inks" bzw. "e-inks") oder "electronic paper" ("e-paper") geeignet.
Bei der Herstellung von Farbfiltern, sowohl reflektierender wie durchsichtiger Farbfilter, werden Pigmente in Form einer Paste oder als pigmentierte Photoresists in geeigneten Bindemitteln (Acrylate, Acrylester, Polyimide, Polyvinylalkohole, Epoxide, Polyester, Melamine, Gelantine, Caseine) auf die jeweiligen LCD-Bauteilen (z.B. TFT-LCD = Thin Film Transistor Liquid Crystal Displays oder z.B. ((S) TN-LCD = (Super) Twisted Nematic-LCD) aufgebracht. Neben einer hohen Thermostabilität ist für eine stabile Paste bzw. einen pigmentierten Photoresist auch eine hohe Pigmentreinheit Voraussetzung. Darüber hinaus können die pigmentierten Color Filter auch durch Ink Jet-Druckverfahren oder andere geeignete Druckverfahren aufgebracht werden.

Die Rotfarbtöne der erfindungsgemäßen Pigmentzubereitungen sind ganz besonders gut geeignet für den Color Filter Farbset Rot-Grün-Blau (R,G,B). Diese drei Farben liegen als getrennte Farbpunkte nebeneinander vor, und ergeben von hinten durchleuchtet ein Vollfarbbild.
Typische Farbmittel für den roten Farbpunkt sind Pyrrolopyrrol-, Chinacridon- und Azopigmente, wie z.B. C.I. Pigment Red 254, C.I. Pigment Red 209, C.I. Pigment Red 175 und C.I. Pigment Orange 38, einzeln oder gemischt. Für den grünen Farbpunkt werden typischerweise Phthalocyaninfarbmittel eingesetzt, wie z.B. C.I. Pigment Green 36 und C.I. Pigment Green 7.
Bei Bedarf können den jeweiligen Farbpunkten noch weitere Farben zum Nuancieren zugemischt werden. Für den Rot- und Grünfarbton wird bevorzugt mit Gelb abgemischt, zum Beispiel mit C.I. Pigment Yellow 138,139,150,151,180 und 213.

In den folgenden Beispielen bedeuten Prozentangaben Gewichtsprozente und Teile Gewichtsteile, sofern nicht anders angegeben.

Die Bestimmung der coloristischen Eigenschaften erfolgte nach DIN 55986.
Zur Bestimmung der Viskosität wird eine 10 %ige Suspension der Pigmentzubereitung in PGMEA (Propylenglykolmonomethyletheracetat) unter Anwesenheit eines handelsüblichen, hochmolekularen Block-Copolymers im Paintshaker Disperse DAS 200 der Firma Lau GmbH dispergiert. Die so erhaltene Mill Base wird mit einem Kegel-Platte Viskosimeter Haake RS75 bei 20 °C vermessen.

### Beispiel 1: Perlmahlung von C.I. Pigment Red 254 in Gegenwart eines DPP-basierenden Pigmentdispergators

Ein Gemisch aus 10 g P.R. 254, 360 g Zirkonmischoxid-Perlen (0.3-0.4 mm), 90 g Wasser und 0,5 g eines Pigmentdispergators der Formel (IV), 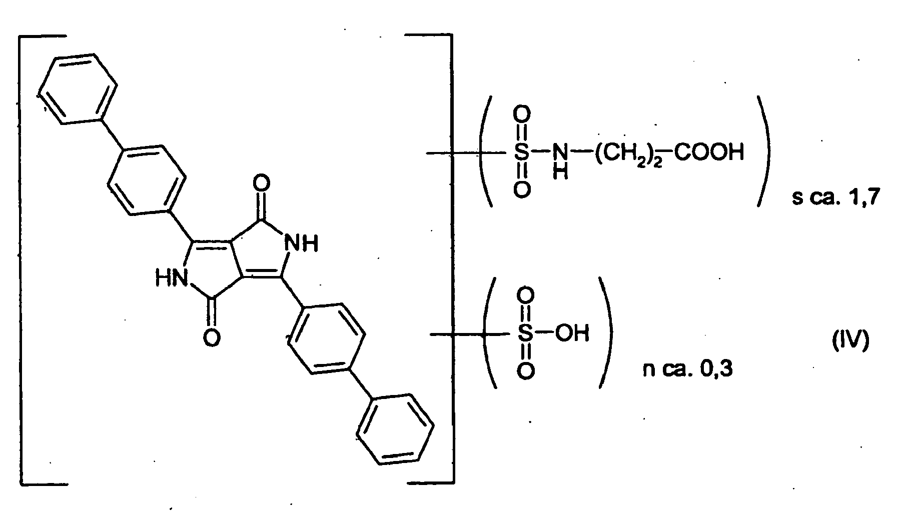 der gemäß Beispiel 1a aus der EP-A-1 362 081 hergestellt wurde, wird in einer Drais® PML-Mühle für 15 min gemahlen. Das Mahlgut wird von den Perlen getrennt, filtriert und der Filterkuchen mit einer 1:1-Mischung aus Wasser und Isobutanol bei pH 7 in Gegenwart von Phosphatpuffer für 5 h zum Rückfluss erhitzt, nach der Wasserdampfdestillation abfiltriert, mit Wasser phosphatfrei gewaschen, im Vakuum getrocknet und abschließend pulverisiert. Man erhält 8,3 g einer roten Pigmentzubereitung mit einer mittleren Teilchengröße von 63 nm (TEM).

### Beispiel 2: Perlmahlung von C.I. Pigment Red 254 mit Fließverbesserer und Zugabe eines DPP-basierenden Pigmentdispergators vor einer Lösungsmittelbehandlung

Ein Gemisch aus 2564 g eines wasserfeuchten Filterkuchens von P.R. 254 (39 %) und 100 g eines handelsüblichen Fließverbesserers auf Naphthalinsulfonsäure-Basis, wird homogen angeteigt und mit einer Drais® Super Flow Mühle in Gegenwart von 2190 g Zirkonmischoxid-Perlen (0.3-0.4 mm) gemahlen, wobei die Pigmentkonzentration durch allmähliche Zugabe von Wasser auf 10 % eingestellt wird. Die Mahldauer entspricht zwei bis drei theoretischen Mahlpassagen. Die Mahlsuspension wird mit 50 g eines Pigmentdispergators, der analog zu Beispiel 1 a aus der EP-A-1 362 081 hergestellt wurde, und Isobutanol versetzt, so dass eine 1:1-Mischung aus Isobutanol und Wasser entsteht. Die Suspension wird bei pH 7 in Gegenwart eines Phosphatpuffers für 2 h zum Rückfluss erhitzt, nach der Abtrennung des Isobutanols durch Wasserdampfdestillation abfiltriert, mit Wasser phosphatfrei gewaschen, im Vakuum getrocknet und abschließend pulverisiert. Man erhält 850 g einer roten Pigmentzubereitung mit einer mittleren Teilchengröße von 54 nm.

### Beispiel 3: Perlmahlung von C.I. Pigment Red 254 in Gegenwart eines Perylenbasierenden Pigmentdispergators

Ein Gemisch aus 10 g P.R. 254, 360 g Zirkonmischoxid-Perien (0.3-0.4 mm), 90 g Wasser und 0.5 g eines Pigmentdispergators, der analog zu Beispiel 3 der EP-A-486 531 hergestellt wurde, wird in einer Drais® PML-Mühle für 15 min gemahlen. Das Mahlgut wird von den Perlen getrennt, filtriert und der Filterkuchen mit einer 1:1-Mischung aus Wasser und Isobutanol bei pH 7 in Gegenwart von Phosphatpuffer für 5 h zum Rückfluss erhitzt, nach der Wasserdampfdestillation abfiltriert, mit Wasser phosphatfrei gewaschen, im Vakuum getrocknet und abschließend pulverisiert. Man erhält 9,2 g einer roten Pigmentzubereitung mit einer mittleren Teilchengröße von 97 nm.

### Beispiel 4 Trockenmahlung von C. I. Pigment Red 254 in Gegenwart von DPP-basierenden Pigmentdispergatoren

Ein Gemisch aus 15 g P.R. 254, 0.75 g eines Pigmentdispergators, der analog zu Beispiel 10a aus der EP 1 104 789 hergestellt wurde, 75 g Natriumsulfat und 700 g Cylpeps® wird für 8 h auf einer Schwingmühle gemahlen. Die Mischung wird in 300 ml Wasser eingerührt, mit Schwefelsäure angesäuert, für 1 h bei 60 °C gerührt, filtriert und der Filterkuchen mit Wasser neutral gewaschen. Der Filterkuchen wird mit einer 1:1-Mischung aus Wasser und Isobutanol bei pH 7 in Gegenwart von Phosphatpuffer und 0,75 g eines Pigmentdispergators, hergestellt nach Beispiel 1a aus der EP-A-1 362 081 für 5 h zum Rückfluss erhitzt, nach der Wasserdampfdestillation abfiltriert, mit Wasser phosphatfrei gewaschen, im Vakuum getrocknet und abschließend pulverisiert. Man erhält 14,6 g einer roten Pigmentzubereitung mit einer mittleren Teilchengröße von 40 nm (TEM).

### Beispiel 5: Salzknetung von C. I. Pigment Red 254 in Gegenwart eines DPP-basierenden Pigmentdispergators

Ein Gemisch aus 15 g P.R. 254, 0,75 g eines Pigmentdispergators, der analog zu Beispiel 1a aus der EP 1 362 081 hergestellt wurde, 90 g mikrokristallinem Natriumchlorid und 15 g Diethylenglykol werden bei 100-105°C für 16 Stunden auf einem 0,3-Liter-Kneter Typ De 034 s der Stephan Werke Hameln geknetet. Die Knetmasse wird für zwei Stunden bei 90°C in 200 ml Salzsäure (5 %) gerührt, der Feststoff abfiltriert, mit Wasser neutral gewaschen und getrocknet. Man erhält 15g einer roten Pigmentzubereitung mit einer mittleren Teilchengröße von 48 nm.

### Vergleichsbeispiel A: Perlmahlung von C.I. Pigment Red 254 in Gegenwart eines Fließverbesserers ohne einen Pigmentdispergator

Ein Gemisch aus 2564 g eines wasserfeuchten Filterkuchens von P.R. 254 (39 %) und 100 g eines handelsüblichen Fließverbesserers auf Naphthalinsulfonsäure-Basis, wird homogen angeteigt und mit einer Drais® Super Flow Mühle in Gegenwart von 2190 g Zirkonmischoxid-Perlen (0,3-0,4 mm) gemahlen, wobei die Pigmentkonzentration durch allmähliche Zugabe von Wasser auf 10 % eingestellt wird. Die Mahldauer entspricht zwei bis drei theoretischen Mahlpassagen. Die Mahlsuspension wird mit Isobutanol versetzt, so dass eine 1:1-Mischung aus Isobutanol und Wasser entsteht. Die Suspension wird bei pH 7 in Gegenwart eines Phosphatpuffers für 2 h zum Rückfluss erhitzt, nach der Abtrennung des Isobutanols durch Wasserdampfdestillation abfiltriert, mit Wasser phosphatfrei gewaschen, im Vakuum getrocknet und abschließend pulverisiert. Man erhält 800 g eines roten Pigments mit einer mittleren Teilchengröße von 100 nm (TEM).

### Vergleichsbeispiel B: Trockenmahlung von C. I. Pigment Red 254 ohne Pigmentdispergator

Die Mahlung wird analog zu Beispiel 4 mit 20 g P.R. 254, jedoch ohne Zugabe von Pigmentdispergatoren durchgeführt. Man erhält 17.8 g eines roten Pigments mit einer mittleren Teilchengröße von 125 nm.

**Tabelle 1: Korngrößenverteilung und Standardabweichung**

| Probe | d50 [nm] | Standardabweichung σ [nm] |
|---|---|---|
| Beispiel 1 | 63 | 20 |
| Beispiel 2 | 54 | 26 |
| Beispiel 3 | 97 | 52 |
| Beispiel 4 | 40 | 11 |
| Beispiel 5 | 48 | 38 |
| Vergleichsbeispiel A | 100 | 39 |
| Vergleichsbeispiel B | 125 | 41 |

Für die Teilchengrößenverteilung wird eine Serie elektronenmikroskopischer Aufnahmen verwendet. Die Primärteilchen werden visuell identifiziert. Die Fläche jeden Primärteilchens wird Hilfe eines graphischen Tabletts bestimmt. Aus der Fläche wird der Durchmesser des flächengleichen Kreises ermittelt. Die Häufigkeitsverteilung der so berechneten Äquivalentdurchmesser wird bestimmt und die Häufigkeiten in Volumenanteile umgerechnet und als Teilchengrößenverteilung dargestellt.
Die Standardverteilung ist ein Maß für die Breite der Verteilung. Je kleiner die Standardabweichung ist, desto schmaler ist die Teilchengrößenverteilung.

**Tabelle 2: Kristallinität**

| Probe | Halbwertsbreite [°2θ] (Hauptpeak) |
|---|---|
| Beispiel 1 | 0.405 |
| Beispiel 2 | 0.430 |
| Beispiel 3 | 0,367 |
| Beispiel 4 | 0.462 |
| Beispiel 5 | 0.537 |

Unter Halbwertsbreite HWB versteht man die Breite des Reflexes in halber Höhe (Hälfte des Maximums) des jeweils größten Peaks (bei 28°).
Die Halbwertsbreite der Proben wird mit einem STOE /θ-Diffraktometer (Cu-K_{α}. U = 40 kV, I = 40 mA) gemessen (Blenden: primärseitig/vertikal 2 x 8 mm, primärseitig/ horizontal 1,0 mm, sekundärseitig 0,5 mm). Als Probenträger wird ein Standard-Stahlträger verwendet. Die Messzeit ist an die gewünschte statistische Sicherheit angepasst, der Winkelbereich 2θ beträgt in der Übersichtsmessung 5 - 30° und die Schrittweite 0,02° mit einer Zeitperiode von 3 s. Im Spezialbereich wird von 23 - 30° mit einer Schrittweite von 0,02° und einer Zeitperiode von 6 s gemessen.
Der Röntgenstrahl wird durch einen Graphit-Sekundärmonochromator monochromatisiert und mit einem Szintillationszähler unter kontinuierlicher Probendrehung vermessen. Zur Auswertung wird ein Profilfit über den gesamten Winkelbereich der zweiten Messung 2θ = 23 - 30° durchgeführt (Fitfunktion: Lorentz² (4 Reflexe)).

### Viskosität einer Mill-base für Colorfilter-Anwendungen

10 g Pigment bzw. Pigmentzubereitung aus den vorher beschriebenen Beispielen werden in 73 g PGMEA (Propylenglykolmonomethyletheracetat) suspendiert, mit 17 g eines handelsüblichen, hochmolekularen Block-Copolymers und 250 g Zirkonoxidperlen (0,3 mm) versetzt und für drei Stunden im Paintshaker Disperse DAS 200 der Firma Lau GmbH, dispergiert.
Zur Bestimmung der Viskosität der Mill-Base wird ein Kegel-Platte Viskosimeter Haake RS75 bei 20 °C verwendet.

| Probe | Dispergatorzugabe bei der Perlmahlung | Viskosität [mPas] |
|---|---|---|
| Beispiel 1 | 5 % Dispergator | 14 |
| Beispiel 2 | 10 % Dispergator vor dem Finish | 11 |
| Beispiel 3 | 5 % Dispergator | 9 |
| Beispiel 4 | Jeweils 5 % Dispergator bei Mahlung und Finish | 17 |
| Vergleichsbeispiel A | Kein Dispergator | 94 |
| Vergleichsbeispiel B | Kein Dispergator | 77 |

Die beschriebenen Pigmentzubereitungen werden mit Hilfe eines Spincoaters (POLOS Wafer Spinner) auf Glasplatten (SCHOTT, Laser-geschnitten, 10 x 10 cm) aufgetragen. Aufgrund der niedrigen Viskositäten erhält man brilliante, hochtransparente, rote Ausfärbungen mit geringer Schichtdicke (500 bis 1300 nm) und sehr gutem Kontrastwert (TSUBOSAKAELECTRIC CO.,LTD, Modell CT-1), die vom Farbton der nicht-additivierten Proben nur wenig abweichen.

### Anwendungsbeispiele für Colorfilter-Anwendungen:

7,2 g Joncryl 611 (Styrol-Acrylatharz, Johnson Polymers) werden für eine Stunde in 13,4 g PGMEA gerührt und unter Rühren mit weiteren 42 g PGMEA, 7,2 g Pigment bzw. Pigmentzubereitung, 1,8 g Solsperse 24000 und 0,36 g Solsperse 22000 (Avecia) versetzt. Nach Zugabe von 122 g Zirkonoxid-Perlen (0,5-0,7 mm) wird für zwei Stunden im Paint Shaker dispergiert. Die Pigmentdispersion wird mit Hilfe eines Spincoaters (POLOS Wafer Spinner) auf Glasplatten (SCHOTT, Laser geschnitten, 10x10 cm) aufgetragen und der Kontrastwert (Goniometer DMS 803, Spektrograph CCD-SPECT2) gemessen.
Die Pigmentzubereitungen aus Beispielen 1 bis 5 sind aufgrund ihres hohen Kontrastwertes für Colorfilteranwendungen gut geeignet.

### Anwendungsbeispiele für transparente Einbrenn-Lacke

4 Teile eines Pigments bzw. einer Pigmentzubereitung aus den vorher beschriebenen Beispielen werden mit 96 Teilen eines Gemischs aus 50 Teilen einer 60 gew.-% igen Lösung von Cocosaldehyd-Melamin-Harz in Butanol, 10 Teilen Xylol und 10 Teilen Ethylenglykolmonomethylether in einer Perlmühle für 30 min gemahlen.
Die erhaltene Dispersion wird auf eine Pappkarte aufgetragen und nach 30 min Lufttrocknung für 30 min bei 140 °C eingebrannt. Die Farbstärken der in den vorstehenden Beispielen hergestellten Pigmente oder Pigmentzubereitungen sind in der Tabelle angegeben.
Die Farbstärke gibt an, wie viele Teile TiO₂ notwendig sind, um 1 Teil Buntpigment auf 1/3 Standard-Farbtiefe zu bringen: 1 : x TiO₂
(Farbstärke und ihre Messung ist definiert nach DIN EN ISO 787-26). Als Vergleich (Farbstärke 100%, ΔC = ΔH = 0) dient jeweils eine entsprechend zubereitete Pigmentzubereitung ohne den erfindungsgemäßen Pigmentdispergator.

| Probe | Farbstärke | ΔC | ΔH |
|---|---|---|---|
| Beispiel 1 | 109 % | -0,04 | 0,08 |
| Beispiel 2 | 113 % | 0,82 | -1,29 |
| Beispiel 3 | 112 % | 1,14 | 0,43 |
| Beispiel 4 | 114 % | 0,04 | -1,85 |

## Patentansprüche

1. Pigmentzubereitung, **gekennzeichnet durch** einen Gehalt von C.I. Pigment Red 254 mit einer mittleren Teilchengröße d₅₀ von 20 bis 100 nm, und mindestens einem Pigmentdispergator der Formel (II) und/oder (III) 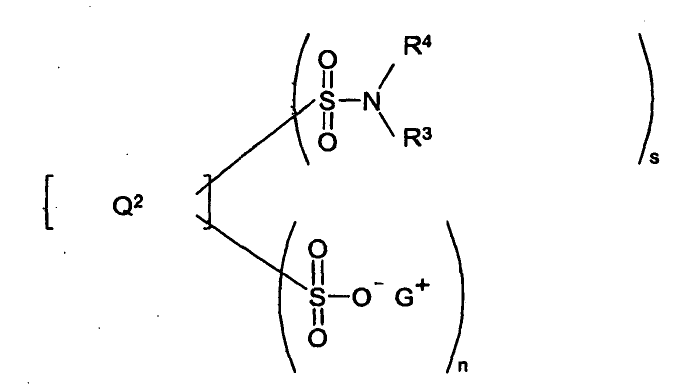 worin
Q² ein Rest eines organischen Pigments ausgewählt aus der Gruppe C.I. Pigment Red 264 und C.I. Pigment Violet 19 ist;
s eine Zahl von 1 bis 5 darstellt;
n eine Zahl von 0 bis 4 darstellt; wobei die Summe von s und n 1 bis 5 beträgt;
R³ einen verzweigten oder unverzweigten, gesättigten oder ungesättigten, aliphatischen Kohlenwasserstoffrest mit 1 bis 20 C-Atomen, oder einen C₅-C₇-Cycloalkylenrest, oder einen araliphatischen oder aromatischen Rest mit 1, 2 oder 3 aromatischen Ringen, wobei die Ringe kondensiert vorliegen oder durch eine Bindung verknüpft sein können, oder einen heterocyclischen Rest mit 1, 2 oder 3 Ringen, enthaltend 1, 2, 3 oder 4 Heteroatome aus der Gruppe O, N und S, oder eine Kombination davon bedeutet; wobei die genannten Kohlenwasserstoff-, Cycloalkylen-, Aromaten-, Araliphaten- und Heteroaromaten-Reste **durch** 1, 2, 3 oder 4 Substituenten aus des Gruppe
order SO₃R⁵ substituiert sind, wobei R⁵ Wasserstoff, Phenyl oder C₁-C₆-Alkyl bedeutet;
R⁴ Wasserstoff, R³ oder C₁-C₆-Alkyl-COO-E⁺ bedeutet;
E⁺, G⁺ unabhängig voneinander H⁺ oder das Äquivalent M^{p+}/m eines Metallkations M^{p+} aus der 1. bis 5. Hauptgruppe oder aus der 1. oder 2. oder der 4. bis 8. Nebengruppe des Periodensystems der chemischen Elemente bezeichnet, wobei m eine der Zahlen 1, 2 oder 3 und p die Zahl 1, 2 oder 3 bedeutet; oder ein substituiertes oder unsubstituiertes Ammoniumion bezeichnet; 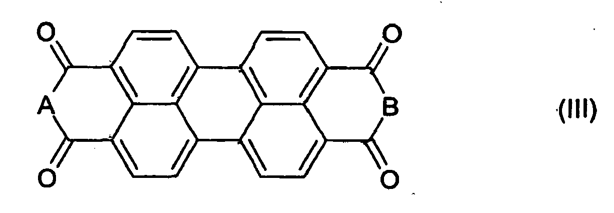
worin
A einen bivalenten Rest -O-, -NR³-, -NR¹⁶-SO₃-G+_{.}
B einen bivalenten Rest -NR¹⁶-SO₃-G⁺,
wobei R¹⁶ für eine geradkettige oder verzweigte C₁-C₆-Alkylenkette steht und R³ und G⁺ die vorstehend genannten Bedeutungen besitzen.

2. Pigmentzubereitung nach Anspruch 1, **dadurch gekennzeichnet, dass** in der Verbindung der Formel (II) s eine Zahl von 1 bis 3, und n eine Zahl von 0 bis 2 bedeuten.

3. Pigmentzubereitung nach Anspruch 1 oder 2, **dadurch gekennzeichnet, dass** das Gewichtsverhältnis von C.I. Pigment Red 254 zum Pigmentdispergator zwischen (99,9 zu 0,1) und (80 zu 20) liegt.

4. Pigmentzubereitung nach einem oder mehreren der Ansprüche 1 bis 3, **dadurch gekennzeichnet, dass** das Gewichtsverhältnis von C.I. Pigment Red 254 zum Pigmentdispergator zwischen (99 zu 1) und (89 zu 11) liegt.

5. Pigmentzubereitung nach einem oder mehreren der Ansprüche 1 bis 4, **gekennzeichnet durch** eine Viskosität von 3 bis 50 mPas.

6. Pigmentzubereitung nach einem oder mehreren der Ansprüche 1 bis 5, **gekennzeichnet durch** eine Halbwertsbreite des Hauptpeaks von 0,2 bis 0,7 °2Theta im Röntgenpulverdiffraktogramm mit CuKₐₗₚₕₐ Strahlung.

7. Pigmentzubereitung nach einem oder mehreren der Ansprüche 1 bis 6, **dadurch gekennzeichnet, dass** ΔH (nach CIELAB), verglichen mit C.I. Pigment Red 254 bei 1/3 Standard-Farbtiefe und gleicher Teilchengröße, nicht größer als 2 ist.

8. Pigmentzubereitung nach einem oder mehreren der Ansprüche 1 bis 7, **dadurch gekennzeichnet, dass** ΔC (nach CIELAB), verglichen mit C.I. Pigment Red 254 bei 1/3 Standard-Farbtiefe und gleicher Teilchengröße, nicht größer als 2 ist.

9. Verfahren zur Herstellung einer Pigmentzubereitung nach einem oder mehreren der Ansprüche 1 bis 8, **dadurch gekennzeichnet, dass** man C.I. Pigment Red 254 vor oder während einer Knetung, Nassmahlung, Trockenmahlung oder Finishbehandlung mit dem Pigmentdispergator der Formel (II) und/oder (III) versetzt.

10. Verwendung einer Pigmentzubereitung nach mindestens einem der Ansprüche 1 bis 8 zum Pigmentieren von hochmolekularen organischen Materialien natürlicher oder synthetischer Herkunft, insbesondere von Kunststoffen, Harzen, Lacken, Anstrichfarben, elektrophotographischen Tonern und Entwicklern, Elektretmaterialien, Farbfiltern sowie von Tinten, Druckfarben.

11. Hochmolekulares organisches Material, enthaltend eine färberisch wirksame Menge einer Pigmentzubereitung nach einem oder mehreren der Ansprüche 1 bis 8.

12. Farbfilter, enthaltend eine färberisch wirksame Menge einer Pigmentzubereitung nach einem oder mehreren der Ansprüche 1 bis 8.

## Claims

1. A pigment preparation comprising C.I. Pigment Red 254 having an average particle size d₅₀ of 20 to 100 nm and at least one pigment dispersant of the formula (II) and/or (III) 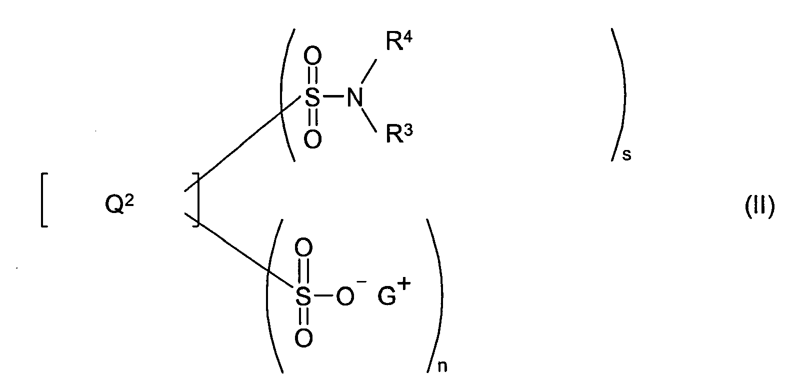 in which
Q² is the radical of an organic pigment selected from the group of C.I. Pigment Red 264 and C.I. Pigment Violet 19;
s is a number from 1 to 5;
n is a number from 0 to 4, the sum of s and n being 1 to 5;
R³ is a branched or unbranched, saturated or unsaturated, aliphatic hydrocarbon radical having 1 to 20 carbon atoms, or is a C₅-C₇ cycloalkylene radical, or is an araliphatic or aromatic radical having 1, 2 or 3 aromatic rings, it being possible for the rings to be fused or to be linked by a bond, or is a heterocyclic radical having 1, 2 or 3 rings containing 1, 2, 3 or 4 heteroatoms from the group O, N and S, or a combination thereof; the stated hydrocarbon, cycloalkylene, aromatic, araliphatic, and heteroaromatic radicals being substituted by 1, 2, 3 or 4 substituents from the group of COOR⁵ or SO₃R⁵, with R⁵ being hydrogen, phenyl or C₁-C₆ alkyl;
R⁴ is hydrogen, R³ or C₁-C₆ alkyl-COO⁻E⁺;
E⁺, G⁺ independently of one another are H⁺ or the equivalent M^{p+}/m of a metal cation M^{p+} from main group 1 to 5 or from transition group 1 or 2 or 4 to 8 of the Periodic Table of the Elements, m being one of the numbers 1, 2 or 3 and p being the number 1, 2 or 3; or is a substituted or unsubstituted ammonium ion; 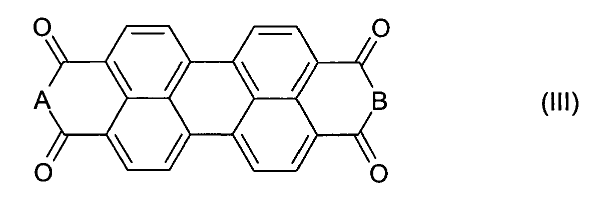
in which
A is a divalent radical -O-, -NR³-, -NR¹⁶-SO₃-G⁺,
B is a divalent radical -NR¹⁶-SO₃-G⁺, R¹⁶ being a linear or branched C₁-C₆ alkylene chain and R³ and G⁺ being as defined above.

2. The pigment preparation as claimed in claim 1, wherein in the compound of the formula (II) s is a number from 1 to 3 and n is a number from 0 to 2.

3. The pigment preparation as claimed in claim 1 or 2, wherein the weight ratio of C.I. Pigment Red 254 to the pigment dispersant is between (99.9:0.1) and (80:20) .

4. The pigment preparation as claimed in one or more of claims 1 to 3, wherein the weight ratio of C.I. Pigment Red 254 to the pigment dispersant is between (99:1) and (89:11).

5. The pigment preparation as claimed in one or more of claims 1 to 4, having a viscosity of 3 to 50 mPas.

6. The pigment preparation as claimed in one or more of claims 1 to 5, having a main-peak width at half peak height of 0.2 to 0.7°2theta in the X-ray powder diffractogram with CuKₐₗₚₕₐ radiation.

7. The pigment preparation as claimed in one or more of claims 1 to 6, wherein ΔSH (according to CIELAB), compared with C.I. Pigment Red 254 at 1/3 standard color depth and identical particle size, is not greater than 2.

8. The pigment preparation as claimed in one or more of claims 1 to 7, wherein ΔC (according to CIELAB), compared with C.I. Pigment Red 254 at 1/3 standard color depth and identical particle size, is not greater than 2.

9. A process for preparing a pigment preparation as claimed in one or more of claims 1 to 8, which comprises admixing C.I. Pigment Red 254 with the pigment dispersant of the formula (II) and/or (III) before or during an operation of kneading, wet grinding, dry grinding or finishing.

10. The use of a pigment preparation as claimed in at least one of claims 1 to 8 for pigmenting high molecular mass organic materials of natural or synthetic origin, especially plastics, resins, varnishes, paints, electrophotographic toners and developers, electret materials, color filters, and inks, including printing inks.

11. A high molecular mass organic material comprising a coloristically effective amount of a pigment preparation as claimed in one or more of claims 1 to 8.

12. A color filter comprising a coloristically effective amount of a pigment preparation as claimed in one or more of claims 1 to 8.

## Revendications

1. Préparation de pigment, **caractérisée par** une teneur en pigment rouge C.I. Pigment Red 254 ayant une taille moyenne de particule d₅₀ de 20 à 100 nm, et en au moins un dispersant pigmentaire de formule (II) et/ou de formule (III) 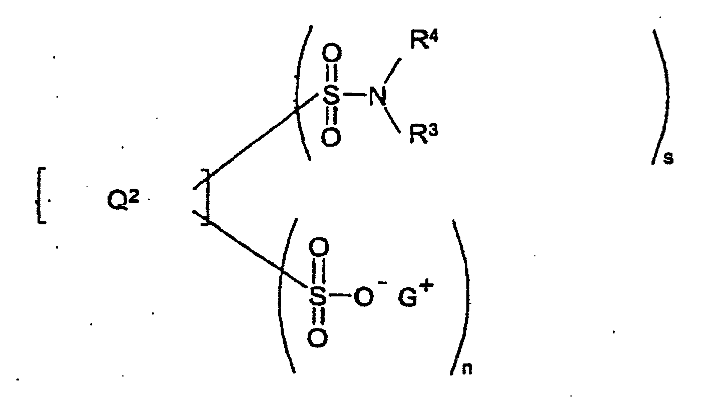 dans laquelle
Q² est le reste d'un pigment organique choisi dans le groupe constitué par le C.I. Pigment Red 264 et le C.I. Pigment Violet 19 ;
s représente un nombre allant de 1 à 5 ;
n représente un nombre allant de 0 à 4 ; la somme de s et n allant de 1 à 5 ;
R³ représente un radical hydrocarboné aliphatique saturé ou insaturé, ramifié ou non ramifié, ayant de 1 à 20 atomes de carbone, ou un radical cycloalkylène en C₅-C₇, ou un radical araliphatique ou aromatique à 1, 2 ou 3 cycles aromatiques, les cycles pouvant être condensés ou être liés par une liaison, ou un radical hétérocyclique à 1, 2 ou 3 cycles, contenant 1, 2, 3 ou 4 hétéroatomes choisis parmi O, N et S ou une association de ceux-ci ; les radicaux hydrocarboné, cycloalkylène, aromatique, araliphatique et hétéroaromatique cités portant 1, 2, 3 ou 4 substituants choisis dans le groupe constitué par COOR⁵ et SO₃R⁵, R⁵ représentant un atome d'hydrogène, un groupe phényle ou alkyle en C₁-C₆ ;
R⁴ représente un atome d'hydrogène, R³ ou un groupe alkyl(C₁-C₆)-COO E ;
E⁺, G⁺ représentent, indépendamment l'un de l'autre, H⁺ ou l'équivalent M^{p+}/m d'un cation M^{p+} d'un métal choisi dans les groupes 1A à 5A ou 1B ou 2B ou 4B à 8B du Système Périodique des Éléments chimiques, m représentant l'un des nombres 1, 2 et 3 et p représentant le nombre 1, 2 ou 3 ; ou représentent un ion ammonium substitué ou non substitué ; 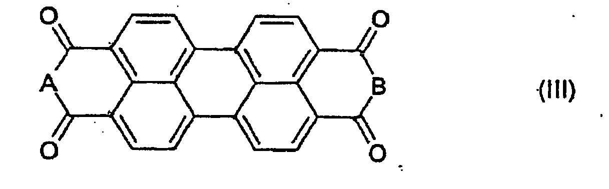
dans laquelle
A représente un radical divalent -O-, -NR³-, -NR¹⁶-SO₃-G⁺,
B représente un radical divalent -NR¹⁶-SO₃-G⁺, R¹⁶ représentant une chaîne alkylène en C₁-C₆ droite ou ramifiée et R³ et G⁺ ayant les significations données précédemment.

2. Préparation de pigment selon la revendication 1, **caractérisée en ce que** dans le composé de formule (II) s représente un nombre allant de 1 à 3, et n représente un nombre allant de 0 à 2.

3. Préparation de pigment selon la revendication 1 ou 2, **caractérisée en ce que** le rapport pondéral de C.I. Pigment Red 254 au dispersant pigmentaire est compris entre 99,9:0,1 et 80:20.

4. Préparation de pigment selon une ou plusieurs des revendications 1 à 3, **caractérisée en ce que** le rapport pondéral de C.I. Pigment Red 254 au dispersant pigmentaire est compris entre 99:1 et 89:11.

5. Préparation de pigment selon une ou plusieurs des revendications 1 à 4, **caractérisée par** une viscosité de 3 à 50 mPa.s.

6. Préparation de pigment selon une ou plusieurs des revendications 1 à 5, **caractérisée par** une largeur à mi-hauteur du pic principal de 0,2 à 0,7 en °2thêta dans le diagramme de diffraction des rayons X sur poudre dans la raie Kₐₗₚₕₐ du Cu.

7. Préparation de pigment selon une ou plusieurs des revendications 1 à 6, **caractérisée en ce que** la valeur ΔH (selon CIELAB), par comparaison avec le C.I. Pigment Red 254 à même taille de particule et à 1/3 de l'intensité de couleur standard, n'est par supérieure à 2.

8. Préparation de pigment selon une ou plusieurs des revendications 1 à 7, **caractérisée en ce que** la valeur ΔC (selon CIELAB), par comparaison avec le C.I. Pigment Red 254 à même taille de particule et à 1/3 de l'intensité de couleur standard, n'est par supérieure à 2.

9. Procédé pour la production d'une préparation de pigment selon une ou plusieurs des revendications 1 à 8, **caractérisé en ce qu'**on mélange le C.I. Pigment Red 254, avant ou pendant un malaxage, un broyage par voie humide, un broyage à sec ou un traitement de finissage, avec le dispersant pigmentaire de formule (II) et/ou de formule (III).

10. Utilisation d'une préparation de pigment selon au moins l'une des revendications 1 à 8, pour la pigmentation de matières organiques de masse moléculaire élevée, d'origine naturelle ou synthétique, par exemple de matières plastiques, de résines, de vernis, de peintures, de toners et développeurs électrophotographiques, de matériaux électret, de filtres colorés, ainsi que d'encres, d'encres d'imprimerie.

11. Matériau organique de masse moléculaire élevée, contenant une quantité efficace pour la coloration d'une préparation de pigment selon une ou plusieurs des revendications 1 à 8.

12. Filtre coloré, contenant une quantité efficace pour la coloration d'une préparation de pigment selon une ou plusieurs des revendications 1 à 8.
